# EUROPEAN PATENT SPECIFICATION

(11) **EP 2 579 324 B1**
(45) Date of publication and mention of the grant of the patent: **28.08.2019**
(21) Application number: 11786539.4
(22) Date of filing: 18.05.2011
(51) Int. Cl.: H01L 31/04, H01L 31/0224, H01L 31/05

(54) **SOLAR CELL MODULE AND METHOD FOR MANUFACTURING SAME**
SOLARZELLENMODUL UND VERFAHREN ZU SEINER HERSTELLUNG
MODULE DE CELLULES SOLAIRES ET SON PROCÉDÉ DE FABRICATION

(30) Priority: 28.05.2010 JP 2010122987
(43) Date of publication of application: 10.04.2013
(73) Proprietor: Panasonic Intellectual Property Management Co., Ltd., Osaka-shi, Osaka 540-6207 (JP)
(72) Inventor: TOHODA Satoshi, Moriguchi-shi Osaka 570-8677 (JP)
(74) Representative: Mewburn Ellis LLP
(86) International application number: PCT/JP2011/061432
(87) International publication number: WO 2011/148840

(56) References cited:
- WO-A1-2009/104627
- WO-A1-2011/021655
- JP-A- 63 010 406
- JP-A- 2008 147 567
- JP-A- 2009 164 320
- JP-A- 2009 246 108
- US-A1- 2010 116 314

## Description

### TECHNICAL FIELD

The invention relates to a solar cell module and a method for producing the same.

### BACKGROUND ART

Recently, a solar cell module has been receiving much attention as an energy source imposing a small environmental load.

Generally, a solar cell module includes a plurality of solar cells . The plurality of solar cells are electrically connected with each other in series or in parallel through a wiring material.

Conventionally, solder has been widely used for bonding the solar cell module and the wiring material together. However, the bonding of the solar cell module and the wiring material with each other using the solder requires the solder to be melted. Thus, in the bonding step, the temperature of the solar cell becomes high. As a result, the solar cell might be damaged or deformed.

In view of this situation, the use of a conductive resin adhesive for bonding the solar cell module and the wiring material together has been recently under consideration (see, for example Patent Document 1).

When the solar cell and the wiring material are bonded together using a resin adhesive such as a conductive resin adhesive, the temperature during the bonding step can be made low unlike in the case where the solder is used for the bonding. Thus, the solar cell can be prevented from having damage, deformation, or the like in the step of bonding the wiring material.

Patent Document 1 also describes a technique of electrically connecting an electrode of a solar cell with a wiring material including a conductive body coated with solder, by pressing and embedding the electrode of the solar cell in a solder coating layer of the wiring material. Patent Document 1 describes a technique of achieving satisfactory electrical connection between the electrode of the solar cell and the wiring material by pressing and embedding the electrode of the solar cell in the solder coating layer.

WO 2009/104627 A1 discloses a solar cell module wherein a wiring material is connected onto a connection electrode by a resin adhesive material and the connection electrode has a plurality of projections which are in direct contact with the wiring material.

### PRIOR ART DOCUMENT

### PATENT DOCUMENT

PATENT DOCUMENT 1: WO2008/023795A1

### SUMMARY OF THE INVENTION

### PROBLEMS TO BE SOLVED BY THE INVENTION

Recently, solar cell modules have been increasingly required to achieve higher output. Thus, further reduction of connection resistance between the solar cells and the wiring material has been strongly required.

The invention is made in view of the above point, and an objective thereof is to provide a high-output solar cell module in which contact resistance between solar cells and a wiring material is low.

### MEANS FOR SOLVING THE PROBLEM

A solar cell module according to a first aspect of the invention is set out in claim 1.

The solar cell module may be as described in claim 2.

The solar cell module may be as described in claim 3.

The solar cell module may be as described in claim 4.

The solar cell module may be as described in claim 5.

The solar cell module may be as described in claim 6.

A method according to a second aspect of the invention is set out in claim 7.

### EFFECT OF THE INVENTION

According to the invention, a high-output solar cell module in which contact resistance between solar cells and a wiring material is low can be provided.

### BRIEF DESCRIPTION OF THE DRAWINGS

Fig. 1 is a schematic cross-sectional view of a solar cell module according to one embodiment.
Fig. 2 is a schematic plan view of a solar cell viewed from a light-receiving surface side.
Fig. 3 is a schematic cross-sectional view taken along a line III-III in Fig. 2.
Fig. 4 is an enlarged schematic plan view of a portion IV in Fig. 3.
Fig. 5 is a partially enlarged schematic cross sectional view of a solar cell according to Comparative Example.
Fig. 6 is a partial schematic view of a finger electrode before pressing.
Fig. 7 is a partial schematic view of the finger electrode after pressing.

### DETAILED DESCRIPTION OF EMBODIMENTS

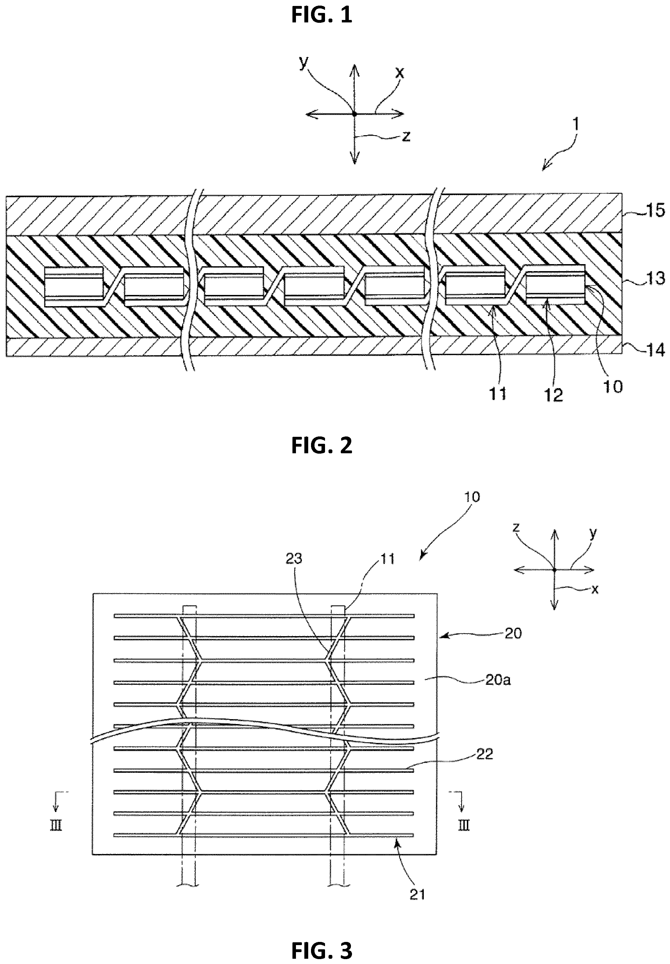

Preferred embodiments of the invention are described with solar cell module 1 shown in Fig. 1 as an example. It is to be noted that solar cell module 1 is merely an example, and the solar cell module according to the invention is not particularly limited to solar cell module 1.

In the drawings referred to in embodiments and modifications, the same reference sign denote materials having substantially the same function. In addition, it should be noted that the drawings referred to in embodiments and the like are schematic and ratios of dimensions and the like of an object in the drawings might be different from actual ones. Moreover, the drawings also include objects having different ratios of dimensions. Therefore, specific ratios of dimensions and the like should be determined in consideration of the following description.

### (Overall Configuration of Solar Cell Module 1)

Fig. 1 is a schematic cross-sectional view of a solar cell module according to one embodiment of the invention. First of all, overall configuration of solar cell module 1 is described with reference to Fig. 1.

As shown in Fig. 1, solar cell module 1 includes a plurality of solar cells 10 arranged along arrangement direction x. Solar cells 10 are electrically connected with each other through wiring materials 11. Specifically, solar cells 10 are electrically connected in series or in parallel with adjacent solar cells 10 being electrically connected with each other through wiring material 11.

First and second protecting materials 14 and 15 are respectively disposed on light-receiving surface and back surface sides of solar cells 10. Sealing material 13 is disposed between first protecting material 14 and second protecting material 15. Solar cells 10 are sealed by sealing material 13.

Materials of sealing material 13 as well as first and second protecting materials 14 and 15 are not particularly limited. For example, sealing material 13 may be made of a translucent resin such as ethylene-vinyl acetate (EVA) copolymer and polyvinyl butyral (PVB) .

For example, first and second protecting materials 14 and 15 may be made of glass, resin, or the like. Alternatively, for example, one of first and second protecting materials 14 and 15 may be made of a resin film in which a metal foil such as an aluminum foil is interposed. In this embodiment, first protecting material 14 is disposed on the back surface side of solar cell 10 and is made of the resin film in which a metal foil such as an aluminum foil is interposed. Second protecting material 15 is disposed on the light-receiving surface side of solar cell 10 and is made of glass or a translucent resin.

A terminal box may be provided on a surface of first protecting material 14.

### (Configuration of Solar Cell 10)

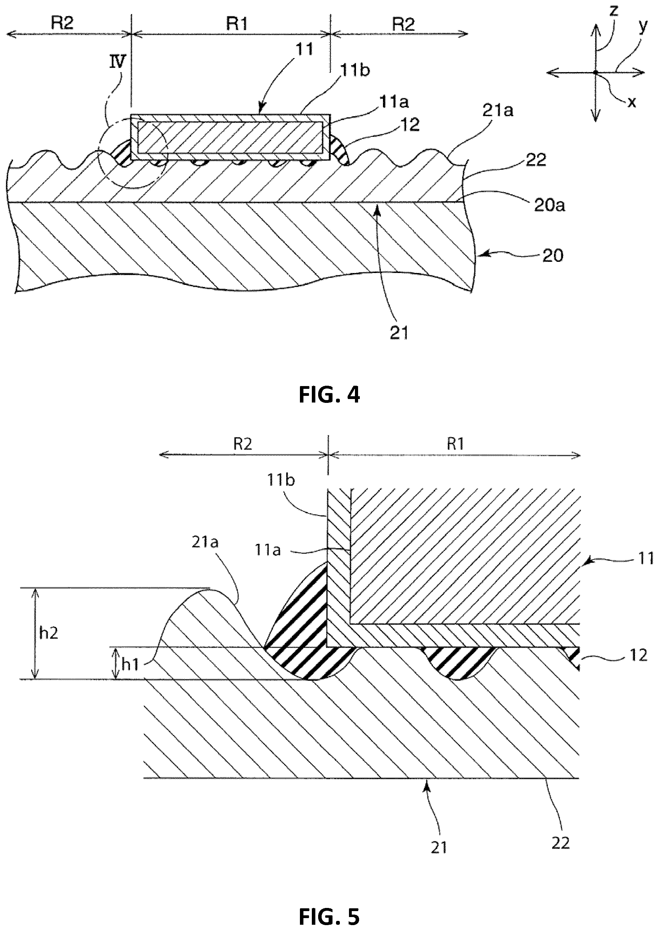

Fig. 2 is a schematic plan view of a solar cell viewed from the light-receiving surface side. Fig. 3 is a schematic cross-sectional view taken along a line III-III in Fig. 2. Fig. 4 is an enlarged schematic plan view of a portion IV in Fig. 3. The configuration of solar cell 10 is described with reference to Fig. 2 to Fig. 4.

Solar cell 10 described herein is merely an example. In the invention, the type and the configuration of the solar cell are not particularly limited.

In this embodiment, one of the main surfaces of the solar cell 10 is the light-receiving surface and the other main surface is the back surface. Alternatively, both main surfaces of the solar cell may be the light-receiving surfaces. In such a case, each of first and second protecting materials 14 and 15 preferably has translucency.

### (Photoelectric Conversion Body 20)

As shown in Fig. 2, solar cell 10 includes photoelectric conversion body 20 that generates carriers (electrons and holes) upon receiving light.

Photoelectric conversion body 20 is made of a semiconductor material with a semiconductor junction such as HIT (registered trademark) junction, pn junction, or pin junction. For example, the semiconductor material includes a crystalline silicon semiconductor such as a single crystal silicon, a polycrystal silicon, or the like, an amorphous silicon semiconductor, and a compound semiconductor such as GaAs.

### (Electrode 21)

Electrode 21 is formed on light-receiving surface 20a of photoelectric conversion body 20. Although omitted in the drawing, electrode 21 is also similarly formed on the back surface of photoelectric conversion body 20. As shown in Fig. 2, electrode 21 includes a plurality of finger electrodes 22 and a plurality of bus bars 23. In the embodiment, the plurality of finger electrodes 22 and the plurality of bus bars 23 are integrally formed.

Finger electrodes 22 each extend in direction y orthogonal to arrangement direction x to be parallel with each other. Finger electrodes 22 are arranged in parallel with each other along arrangement direction x.

Bus bars 23 are formed in a zigzag form along arrangement direction x. Finger electrodes 22 are electrically connected with each other through bus bars 23.

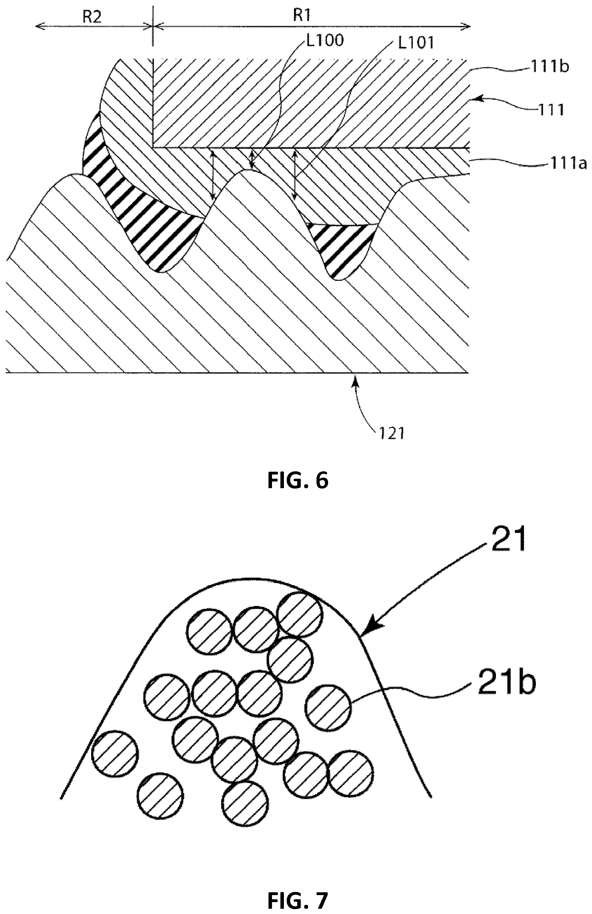

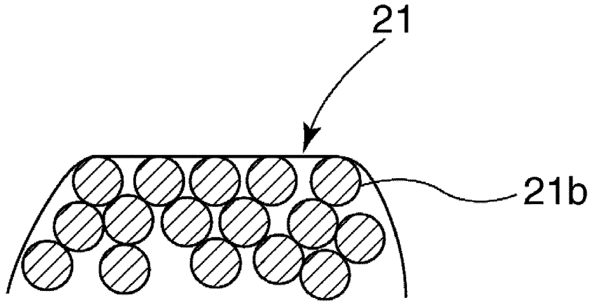

In this embodiment, electrode 21 is formed by printing a conductive paste including a plurality of conductive particles 21b (see Fig. 7) made of a conductive material such as silver. Thus, electrode 21 includes the plurality of conductive particles 21b. In this embodiment, volume content of conductive particles 21b is larger in a region of electrode 21 in direct contact with wiring material 11 than in a region of electrode 21 not in direct contact with wiring material 11.

As shown in Fig. 3 and Fig. 4, surface 21a of electrode 21 formed by screen printing the conductive paste has corrugation. In other words, surface 21a of electrode 21 is a surface having corrugation.

### (Electrical Connection of Solar Cells 10 through Wiring Material 11)

How solar cells 10 are electrically connected through wiring material 11 in the embodiment is described with reference to Fig. 1 to Fig. 4.

As shown in Fig. 1, solar cells 10 adjacently arranged are electrically connected with each other through wiring material 11. Specifically, one end of wiring material 11 is electrically connected to electrode 21 on the light-receiving surface 20a side of solar cell 10, while the other end of wiring material 11 is electrically connected to electrode 21 on the back surface side of solar cell 10 adjacent to solar cell 10 mentioned above. Thus, solar cells 10 adjacently arranged are electrically connected through wiring material 11.

A surface of wiring material 11 is harder than electrode 21. Wiring material 11 includes wiring material main body 11a and coating layer 11b that coats a surface of wiring material main body 11a. In the embodiment, a case where the entire surface of wiring material main body 11b is coated with coating layer 11b is described. The entire surface of wiring material main body 11a does not necessarily have to be coated with coating later 11b. Only the surface of wiring material main body 11a on the side of electrode 21 may be coated with coating layer 11b.

Wiring material main body 11a is made of metal such as Cu or a Cu alloy having a low electrical resistance for example. Like wiring material main body 11a, coating layer 11b is also made of a conductive material. In the embodiment, a material of coating later 11b is harder than a material of electrode 21. Specifically, coating layer 11b is made of metal such as Ag or an alloy such as Ag alloy.

In this embodiment, coating layer 11b at least in a portion of wiring material 11 facing electrode 21 has a uniform thickness. Specifically, in this embodiment, coating layer 11b has a uniform thickness over its entirety. In the invention, "the uniform thickness" includes not only a case where the thickness is completely uniform, but also includes a case where the thickness is substantially uniform.

An average thickness of coating layer 11b is preferably about several µm for example. If coating layer 11b is too thick, the electric resistance of wiring material 11 might be too large. On the other hand, if coating layer 11b is too thin, a property required for coating layer 11b might not be sufficiently obtained.

As shown in Fig. 3 and Fig. 4, in the embodiment, wiring material 11 and solar cell 10 are bonded together by resin adhesive 12. Specifically, wiring material 11 and solar cell 10 are bonded together by resin adhesive 12, while electrode 21 of solar cell 10 and wiring material 11 are in direct contact with each other. Resin adhesive 12 may be made of an insulating resin such as epoxy resin, acryl resin, polyimide resin, phenol resin, urethane resin, silicone resin, or mixture or copolymer of these resins for example. Among these, resin adhesive 12 is preferably made of epoxy resin or acryl resin.

For example, resin adhesive 12 may be that in which a plurality of conductive particles are dispersed in an insulating resin. In such a case, conductive particles may be particles of a metal such as silver, copper, nickel, gold, tin, aluminum, or an alloy including one or more of these metals. Alternatively, the conductive particles may be insulating particles of inorganic material such as alumina, silica, titanium oxide and glass, or organic material such as epoxy resin, acryl resin, polyimide resin, phenol resin, urethane resin, and silicone resin, coated with the metal or alloy described above.

As shown in Fig. 4, maximum height h1 in contact region R1 of electrode 21 in direct contact with wiring material 11 is lower than maximum height h2 in non-contact region R2 of electrode 21 not in direct contact with wiring material 11 (h1<h2).

### (Method for Producing Solar Cell Module 1)

Next, a method for producing solar cell module 1 is described in detail.

First, photoelectric conversion body 20 is prepared. Photoelectric conversion body 20 can be produced by a known method.

Next, electrode 21 is formed on each of light-receiving surface 20a and the back surface of photoelectric conversion body 20, and thus solar cell 10 is completed. In the embodiment, electrode 21 is formed by printing a conductive paste including a plurality of conductive particles 21b. Thus, electrode 21 including the plurality of conductive particles 21b and having surface 21a as a corrugated surface can be formed. The printing of the conductive paste can be implemented through various printing methods such as screen printing, for example.

Next, the plurality of solar cells 10 produced as described above are electrically connected with each other through wiring material 11. Specifically, solar cell 10 and wiring material 11 are pressed until wiring material 11 and electrode 21 come into direct contact with each other while a resin sheet is provided between solar cell 10 and wiring material 11. Specifically, the pressing is performed to such a degree that ridges in the surface of electrode 21 deform in accordance with the shape of the surface of wiring material 11, and maximum height h1 in the region of electrode 21 in direct contact with wiring material 11 becomes lower than maximum height h2 in the region of electrode 21 not in direct contact with wiring material 11, as shown in Fig. 4.

In the state, the resin sheet is cured, and thus solar cell 10 and wiring material 11 are bonded together. The cured resin sheet serves as resin adhesive 12. By repeating the bonding between solar cell 10 and wiring material 11, the plurality of solar cells 10 are electrically connected with each other.

The resin sheet is preferably made of an energy line curable rein such as a thermosetting resin or a light curable resin for example. If the resin sheet is made of the thermosetting resin, the curing temperature of the resin sheet is preferably 200°C or lower.

Next, sealing material 13 and first and second protecting materials 14 and 15 shown in Fig. 1 are prepared. For example, a resin sheet such as an EVA sheet is placed on second protecting material 15. Solar cells 10 electrically connected with each other through wiring material 11 are disposed on the resin sheet. A resin sheet such as an EVA sheet is placed on solar cells 10, and first protecting material 14 is placed on the resin sheet. These are tacked together by being pressed and heated in decompressed atmosphere, and then are heated again so that resin in the resin sheets is cross-linked, and thus sealing material 13 is formed. Through the above described steps, solar cell module 1 can be produced.

A terminal box, a metal frame, and the like may be attached if needed.

### (Case where Electrode is Embedded in Solder Coating Layer of Wiring Material)

Fig. 5 is a partially enlarged schematic cross-sectional view of a solar cell module according to Comparative Example where wiring material 111 and electrode 121 are electrically connected with each other by partly embedding electrode 121 in solder coating layer 111a of wiring material 111.

In the case shown in Fig. 5, the material of solder coating layer 111a is relatively softer than the material of electrode 121, and electrode 121 is partly embedded in solder coating layer 111a. Thus, unlike in the embodiment, the maximum height of electrode 121 in contact region R1 and the maximum height of electrode 121 in non-contact region R2 are substantially the same.

Generally, solder coating layer 111a has a higher electrical resistance than wiring material main body 111b. Thus, even when electrode 121 is embedded in solder coating layer 111, the electrical resistance is high at a contact portion between electrode 121 and wiring material 111 if the distance between electrode 121 and wiring material main body 111b is long. In the case shown in Fig. 5, solder coating layer 111a deforms and electrode 121 does not deform. Thus, while distance L100 between the crest of the ridge of electrode 121 and wiring material main body 111b is short, distance L101 between the other portion of electrode 121 and wiring material main body 111b is relatively long. Accordingly, in the example shown in Fig. 5, the electrical resistance at the contact portion between electrode 121 and wiring material 111 is relatively large. Thus, the output of the solar cell module tends to be small.

In contrast, in the embodiment, unlike Comparative Example shown in Fig. 5 described above, wiring material 11 does not substantially deform and electrode 21 deforms as shown in Fig. 4. Specifically, electrode 21 is deformed to such a degree that maximum height h1 in contact region R1 becomes lower than maximum height h2 in non-contact region R2. Thus, the region in the surface of electrode 21 facing the surface of wiring material 11 includes a portion deformed in accordance with the shape of the surface of wiring material 11. The portion of electrode 21 facing wiring material 11 is more flat than the other portion of electrode 21. Thus, a portion of electrode 21 close to wiring material main body 11a is larger compared with the case shown in Fig. 5. Furthermore, an average distance between electrode 21 and wiring material 11 is shorter. Thus, the electrical resistance at the contact portion between electrode 21 and wiring material 11 is low. For further reducing the electrical resistance at the contact portion between electrode 21 and wiring material 11 in the embodiment where wiring material 11 does not substantially deform, coating layer 11b in the portion of wiring material 11 facing electrode 21 preferably has a uniform thickness.

In the embodiment where electrode 21 is deformed by the pressing, the volume content of conductive particles 21b in the surface layer of electrode 21 increases as shown in Fig. 7 from that in a state before the pressing shown in Fig. 6. Specifically, the volume content of conductive particles 21b is larger in at least the surface layer of contact region R1 than in the surface layer of non-contact region R2. Thus, in the embodiment, the electrical resistance of electrode 21 is low at region R1 in which electrode 21 is in direct contact with wiring material 11.

More conductive particles 21b are exposed on the surface of electrode 21 by the pressing. Specifically, in the embodiment, the amount of conductive particles 21b exposed on the surface of electrode 21 per unit area is larger in contact region R1 than in non-contact region R2. This further reduces the contact resistance between electrode 21 and wiring material 11.

All things considered, with maximum height h1 in contact region R1 being lower than maximum height h2 in non-contact region R2 as in the embodiment, the electrical resistance at the contact portion between electrode 21 and wiring material 11 can be reduced. As a result, high-output solar cell module 1 can be achieved.

In the embodiment, as shown in Fig. 3 and Fig. 4, resin adhesive is provided in at least part of portions between wiring material 11 and troughs of the corrugation on surface 21a of electrode 21. Thus, resin adhesive 12 is positioned on surface 21a of electrode 21 in a dispersed manner. Thus, also surface 21a of electrode 21 and wiring material 11 are partly bonded together by resin adhesive 12. Accordingly, adhesion strength of wiring material 11 can be increased.

In this embodiment, the case is described where electrode 21 includes the plurality of finger electrodes 22 and bus bars 23. It is to be noted that the invention is not limited to this configuration. In the invention, the electrode may include at least one finger electrode.

When the electrode includes the bus bar, the form of the bus bar is not limited to a zigzag form, and may be a linear form, an arc form, or the like for example.

### DESCRIPTION OF REFERENCE NUMERALS

- 1: solar cell module
- 10: solar cell
- 11: wiring material
- 12: resin adhesive
- 13: sealing material
- 14: first protecting material
- 15: second protecting material
- 20: photoelectric conversion body
- 20a: light-receiving surface of photoelectric conversion body
- 21: electrode
- 21a: surface of electrode
- 21b: conductive particle
- 22: finger electrode
- 23: bus bar
- R1: contact region
- R2: non-contact region

## Claims

1. A solar cell module (1) comprising:
a plurality of solar cells (10) that each include a photoelectric conversion body (20) and an electrode (21) formed on a surface of the photoelectric conversion body (20);
a plurality of wiring materials (11), each of which electrically connects two adjacent solar cells (10) of the plurality of solar cells (10) with each other; and
a resin adhesive (12) that bonds the solar cells (10) and the wiring materials (11) together, wherein, for each of the solar cells (10) :
a portion of one of the wiring materials (11) is in direct contact with the electrode (21); and
the electrode (21) has corrugation in a surface,
**characterized in that**:
the corrugation of the electrode (21) is deformed in a first region (R1) of the electrode (21) that is in direct contact with the wiring material (11), the corrugation being deformed in accordance with the shape of a surface of the wiring material (11) that is in direct contact with the electrode (21), such that a maximum height (h1) of the corrugation in the first region (R1) of the electrode (21) that is in direct contact with the wiring material (11) is lower than a maximum height (h2) of the corrugation in a second region (R2) of the electrode (21) that is not in direct contact with the wiring material (11).

2. The solar cell module (1) according to claim 1, wherein
the electrode (21) includes a plurality of conductive particles, and
a volume content of the conductive particles at least in a surface layer of the first region (R1) of the electrode (21) that is in direct contact with the wiring material (11) is larger than that of the conductive particles in a surface layer of the second region (R2) of the electrode (21) that is not in direct contact with the wiring material (11).

3. The solar cell module (1) according to claim 1, wherein the resin adhesive (12) is provided in at least part of portions between the wiring material (11) and troughs of the corrugation in the surface of the electrode (21).

4. The solar cell module (1) according to claim 1, wherein the wiring material (11) includes a wiring material main body (11a) and a coating layer (11b) that coats a surface of the wiring material main body (11a) and is harder than the electrode (21).

5. The solar cell module (1) according to claim 4, wherein the coating layer (11b) in a portion of the wiring material (11) facing the electrode (21) has a uniform thickness.

6. The solar cell module (1) according to claim 1, wherein the deformation of the corrugation in the first region (R1) of the electrode (21) causes the contact area between the electrode (21) and the wiring material (11) to be increased, compared to a case where there is no deformation of the corrugation.

7. A method for producing a solar cell module (1) including: a plurality of solar cells (10) that each includes a photoelectric conversion body (20) and an electrode (21) provided on a surface of the photoelectric conversion body (20); a plurality of wiring materials (11), each of which electrically connects two adjacent solar cells (10) of the plurality of solar cells (10) with each other; and a resin adhesive (12) that bonds the solar cells (10) and the wiring materials (11) together, in which, for each of the solar cells (10), a portion of the wiring material (11) is in direct contact with the electrode (21), and the electrode (21) has corrugation in a surface, **characterized in that** the method comprises:
bonding one of the solar cells (10) and one of the plurality of wiring materials (11) together with the resin adhesive (12) while the electrode (21) and the wiring material (11) are in direct contact with each other in a state where ridges in the surface of the electrode (21) are deformed, by pressing the wiring material (11) against the electrode (21), to such a degree that a maximum height (h1) of the trough and ridges in a region (R1) of the electrode (21) in direct contact with the wiring material (11) is lower than a maximum height (h2) in a region (R2) of the electrode (21) not in direct contact with the wiring material (11).

## Patentansprüche

1. Solarzellenmodul (1), umfassend:
eine Vielzahl von Solarzellen (10), die jeweils einen photoelektrischen Umwandlungskörper (20) und eine Elektrode (21), die auf einer Oberfläche des photoelektrischen Umwandlungskörpers (20) ausgebildet ist, umfassen;
eine Vielzahl von Verdrahtungsmaterialien (11), die jeweils zwei aneinander angrenzende Solarzellen (10) aus der Vielzahl von Solarzellen (10) elektrisch miteinander verbinden; und
einen Harzklebstoff (12), der die Solarzellen (10) und die Verdrahtungsmaterialien (11) miteinander haftschlüssig verbindet, wobei für jede der Solarzellen (10) Folgendes gilt:
ein Abschnitt von einem der Verdrahtungsmaterialien (11) ist in direktem Kontakt mit der Elektrode (21); und
die Elektrode (21) weist eine Wellung in einer Oberfläche auf,
**dadurch gekennzeichnet,**
**dass** die Wellung der Elektrode (21) in einem ersten Bereich (R1) der Elektrode (21), der in direktem Kontakt mit dem Verdrahtungsmaterial (11) ist, verformt ist, wobei die Wellung entsprechend der Form einer Oberfläche des Verdrahtungselements (11) verformt ist, das in direktem Kontakt mit der Elektrode (21) ist, sodass eine Maximalhöhe (h1) der Wellung in dem ersten Bereich (R1) der Elektrode (21), der in direktem Kontakt mit dem Verdrahtungsmaterial (11) ist, kleiner als eine Maximalhöhe (h2) der Wellung in einem zweiten Bereich (R2) der Elektrode (21), der nicht in direktem Kontakt mit dem Verdrahtungsmaterial (11) ist, ist.

2. Solarzellenmodul (1) gemäß Anspruch 1,
wobei die Elektrode (21) eine Vielzahl von leitfähigen Teilchen umfasst, und
wobei ein Volumengehalt der leitfähigen Teilchen zumindest in einer Oberflächenschicht des ersten Bereichs (R1) der Elektrode (21), der in direktem Kontakt mit dem Verdrahtungsmaterial (11) ist, größer als derjenige der leitfähigen Teilchen in einer Oberflächenschicht des zweiten Bereichs (R2) der Elektrode (21), der nicht in direktem Kontakt mit dem Verdrahtungsmaterial (11) ist, ist.

3. Solarzellenmodul (1) gemäß Anspruch 1, wobei der Harzklebstoff (12) in mindestens einem Teil von Abschnitten zwischen dem Verdrahtungsmaterial (11) und Wellenvertiefungen in der Oberfläche der Elektrode (21) vorgesehen ist.

4. Solarzellenmodul (1) gemäß Anspruch 1, wobei das Verdrahtungsmaterial (11) einen Verdrahtungshauptkörper (11a) und eine Beschichtungsschicht (11b) umfasst, die eine Oberfläche des Verdrahtungsmaterialhauptkörpers (11a) bedeckt und härter als die Elektrode (21) ist.

5. Solarzellenmodul (1) gemäß Anspruch 4, wobei die Beschichtungsschicht (11b) in einem Abschnitt des Verdrahtungsmaterials (11), das der Elektrode (21) zugewandt ist, eine gleichmäßige Dicke aufweist.

6. Solarzellenmodul (1) gemäß Anspruch 1, wobei im Vergleich zu einem Fall, in dem keine Verformung der Wellung vorliegt, die Verformung der Wellung in dem ersten Bereich (R1) der Elektrode (21) eine Vergrößerung der Kontaktfläche zwischen der Elektrode (21) und dem Verdrahtungsmaterial (11) bewirkt.

7. Verfahren zur Herstellung eines Solarzellenmoduls (1), umfassend: eine Vielzahl von Solarzellen (10), die jeweils einen photoelektrischen Umwandlungskörper (20) und eine Elektrode (21), die auf einer Oberfläche des photoelektrischen Umwandlungskörpers (20) angeordnet ist, umfassen; eine Vielzahl von Verdrahtungsmaterialien (11), die jeweils zwei aneinander angrenzende Solarzellen (10) aus der Vielzahl von Solarzellen (10) elektrisch miteinander verbinden; und einen Harzklebstoff (12), der die Solarzellen (10) und die Verdrahtungsmaterialien (11) miteinander haftschlüssig verbindet, wobei für jede der Solarzellen (10) ein Abschnitt des Verdrahtungsmaterials (11) in direktem Kontakt mit der Elektrode (21) ist, und die Elektrode (21) eine Wellung in einer Oberfläche aufweist, **dadurch gekennzeichnet, dass** das Verfahren Folgendes umfasst:
haftschlüssiges Verbinden einer der Solarzellen (10) mit einem aus der Vielzahl von Verdrahtungsmaterialien (11) mit dem Harzklebstoff (12), während die Elektrode (21) und das Verdrahtungsmaterial (11) in direktem Kontakt in einem Zustand miteinander sind, in dem Erhöhungen in der Oberfläche der Elektrode (21) verformt werden, indem das Verdrahtungsmaterial (11) in einem solchen Ausmaß gegen die Elektrode (21) gedrückt wird, dass eine Maximalhöhe (h1) der Vertiefung und den Erhöhungen in einem Bereich (R1) der Elektrode (21), der in direktem Kontakt mit dem Verdrahtungsmaterial (11) ist, kleiner als eine Maximalhöhe (h2) in einem Bereich (R2) der Elektrode (21), der nicht in direktem Kontakt mit dem Verdrahtungsmaterial (11) ist, ist.

## Revendications

1. Module de cellules solaires (1) comprenant :
une pluralité de cellules solaires (1) qui comprennent chacune un corps de conversion photoélectrique (20) et une électrode (21) formée sur une surface du corps de conversion photoélectrique (20) ;
une pluralité de matériaux de câblage (11), dont chacun connecte électriquement deux cellules solaires adjacentes (10) de la pluralité de cellules solaires (10) l'une à l'autre ; et
un adhésif de résine (12) qui lie les cellules solaires (10) et les matériaux de câblage (11) les unes aux autres, dans lequel, pour chacune des cellules solaires (10) :
une portion d'un des matériaux de câblage (11) est en contact direct avec l'électrode (21) ; et
l'électrode (21) présente une ondulation dans une surface,
**caractérisé en ce que** :
l'ondulation de l'électrode (21) est déformée dans une première région (R1) de l'électrode (21) qui est en contact direct avec le matériau de câblage (11), l'ondulation étant déformée en fonction de la forme d'une surface du matériau de câblage (11) qui est en contact direct avec l'électrode (21), de sorte qu'une hauteur maximale (h1) de l'ondulation dans la première région (R1) de l'électrode (21) qui est en contact direct avec le matériau de câblage (11) est inférieure à une hauteur maximale (h2) de l'ondulation dans une seconde région (R2) de l'électrode (21) qui n'est pas en contact direct avec le matériau de câblage (11).

2. Module de cellules solaires (1) selon la revendication 1, dans lequel l'électrode (21) comprend une pluralité de particules conductrices, et
un contenu en volume des particules conductrices au moins dans une couche de surface de la première région (R1) de l'électrode (21) qui est en contact direct avec le matériau de câblage (11) est supérieur à celui des particules conductrices dans une couche de surface de la seconde région (R2) de l'électrode (21) qui n'est pas en contact direct avec le matériau de câblage (11).

3. Module de cellules solaires (1) selon la revendication 1, dans lequel l'adhésif de résine (12) est disposé dans au moins une partie de portions entre le matériau de câblage (11) et des creux de l'ondulation dans la surface de l'électrode (21).

4. Module de cellules solaires (1) selon la revendication 1, dans lequel le matériau de câblage (11) comprend un corps principal de matériau de câblage (11a) et une couche de revêtement (11b) qui revêt une surface du corps principal de matériau de câblage (11a) et est plus dure que l'électrode (21).

5. Module de cellules solaires (1) selon la revendication 4, dans lequel la couche de revêtement (11b) dans une portion du matériau de câblage (11) faisant face à l'électrode (21) présente une épaisseur uniforme.

6. Module de cellules solaires (1) selon la revendication 1, dans lequel la déformation de l'ondulation dans la première région (R1) de l'électrode (21) provoque une augmentation de la zone de contact entre l'électrode (21) et le matériau de câblage (11), par rapport à un cas dans lequel il n'y a aucune déformation de l'ondulation.

7. Procédé de production d'un module de cellules solaires (1) comprenant : une pluralité de cellules solaires (10) qui comprennent chacune un corps de conversion photoélectrique (20) et une électrode (21) disposée sur une surface du corps de conversion photoélectrique (20) ; une pluralité de matériaux de câblage (11), dont chacun connecte électriquement deux cellules solaires adjacentes (10) de la pluralité de cellules solaires (10) l'une à l'autre ; et un adhésif de résine (12) qui lie les cellules solaires (10) et les matériaux de câblage (11) ensemble, dans lequel, pour chacune des cellules solaires (10), une partie du matériau de câblage (11) est en contact direct avec l'électrode (21), et l'électrode (21) présente une ondulation dans une surface, **caractérisé en ce que** le procédé comprend :
la liaison d'une des cellules solaires (10) et d'un de la pluralité de matériaux de câblage (11) ensemble avec l'adhésif de résine (12) tandis que l'électrode (21) et le matériau de câblage (11) sont en contact direct l'une avec l'autre dans un état dans lequel des arêtes dans la surface de l'électrode (21) sont déformées, en pressant le matériau de câblage (11) contre l'électrode (21), à un degré tel qu'une hauteur maximale (h1) du creux et des arêtes dans une région (R1) de l'électrode (21) en contact direct avec le matériau de câblage (11) est inférieure à une hauteur maximale (h2) dans une région (R2) de l'électrode (21) qui n'est pas en contact direct avec le matériau de câblage (11) .
